# EUROPEAN PATENT APPLICATION

(11) **EP 4 700 904 A1**
(43) Date of publication of application: **25.02.2026**
(21) Application number: 25193429.5
(22) Date of filing: 01.08.2025
(51) Int. Cl.: H01M 10/48, H01M 10/613, H01M 10/625, H01M 50/204, H01M 50/249, H01M 50/284, B60R 16/03

(54) **ELECTRICAL STORAGE DEVICE AND METHOD OF DETECTING IMPACT LOAD INPUT TO ELECTRICAL STORAGE DEVICE**

(30) Priority: 22.08.2024 JP 2024141154
(71) Applicant: TOYOTA JIDOSHA KABUSHIKI KAISHA, Toyota-shi, Aichi-ken 471-8571 (JP)
(72) Inventor: SASAKI, Manabu, Toyota-shi, 471-8571 (JP)
(74) Representative: TBK

(57) **Abstract**

An electrical storage device includes a plurality of battery cells; a battery case that houses the battery cells; and an impact detection unit which is disposed relative to a wall portion configuring a part of the battery case, the impact detection unit includes conductive members that are disposed so as to overlap with the battery cells as viewed from a predetermined direction and that have a predetermined voltage applied to them, and the impact detection unit includes a cover that is made of an insulator and that covers parts of the conductive members which overlap with the wall portion and parts of the conductive members which overlap with the battery cells as viewed from the predetermined direction.

## Description

### BACKGROUND

### Technical Field

The present disclosure relates to an electrical storage device and a method of detecting an impact load input to an electrical storage device.

### Related Art

Japanese Patent Application Laid-open (JP-A) No. 2004-129367 discloses an invention relating to a vehicle control device. In this vehicle control device, when the detection value of an acceleration sensor is greater than a predetermined acceleration, an electronic control unit (ECU) for an airbag determines that the vehicle has sustained an impact, and electrical power stored in an electrical storage device is discharged.

### SUMMARY

In this connection, what the acceleration sensor detects is mainly acceleration relative to the vehicle body, and the above related art has room for improvement in terms of detecting an impact load that is input to the electrical storage device.

In consideration of the above circumstances, the present disclosure obtains an electrical storage device that can detect an impact load input to the electrical storage device and a method of detecting an impact load input to an electrical storage device.

An electrical storage device pertaining to a first aspect includes: a plurality of battery cells; a battery case that houses the battery cells; and an impact detection unit that is disposed relative to a wall portion configuring a part of the battery case and the impact detection unit includes conductive members that are disposed so as to overlap with the battery cells as viewed from a predetermined direction and have a predetermined voltage applied to them and the impact detection unit includes a cover made of an insulator that covers the parts of the conductive members that overlap with the wall portion and the parts of the conductive members that overlap with the battery cells as viewed from the predetermined direction.

According to the electrical storage device pertaining to the first aspect, the electrical storage device includes the plural battery cells, and by installing the electrical storage device in a vehicle for example, electrical power can be supplied from the battery cells to various devices installed in the vehicle.

In this connection, vehicles usually have an acceleration sensor installed in the front or rear portion of the vehicle body, and although the acceleration sensor can detect an impact load input to the vehicle body, it is difficult for the acceleration sensor to detect whether an impact load has been input to the electrical storage device installed in the vehicle.

Here, in this aspect, the impact detection unit is disposed relative to the wall portion configuring a part of the battery case that houses the battery cells, and the impact detection unit can detect whether an impact load has been input to the electrical storage device.

More specifically, the impact detection unit is configured to include the conductive members and the cover made of an insulator. The conductive members are disposed so as to overlap with the battery cells as viewed from the predetermined direction and have a predetermined voltage applied to them.

The cover covers the parts of the conductive members that overlap with the wall portion of the battery case and the parts of the conductive members that overlap with the battery cells as viewed from the predetermined direction and insulate the conductive members from the wall portion and the battery cells.

For this reason, in this aspect, when an impact load is input to the electrical storage device, the conductive members break or deform with the deformation of the cover, resulting in a drop in the voltages output from the conductive members. That is, in this aspect, whether an impact load has been input to the electrical storage device can be determined based on the voltages output from the conductive members.

An electrical storage device pertaining to a second aspect is the electrical storage device pertaining to the first aspect, further including a cooling unit that is disposed relative to the wall portion, wherein the impact detection unit is disposed between the battery cells and the cooling unit, and heat transfer between the battery cells and the cooling unit is performed via the cover.

According to the electrical storage device pertaining to the second aspect, the cooling unit is disposed relative to the wall portion of the battery case, and the impact detection unit is disposed between the battery cells and the cooling unit. Heat transfer between the battery cells and the cooling unit is performed via the cover.

For this reason, in this aspect, during cooling of the battery cells by the cooling unit, heat exchange between the cooling unit and the battery cells can be promoted, and the efficiency with which the battery cells are cooled can be improved.

An electrical storage device pertaining to a third aspect is the electrical storage device pertaining to the second aspect, wherein the cover is in contact with the battery cells.

According to the electrical storage device pertaining to the third aspect, the cover and the battery cells are in contact with each other, and an impact load that is input to the battery cells and an impact load that is input to the impact detection unit can be approximated.

An electrical storage device pertaining to a fourth aspect is the electrical storage device pertaining to the second aspect or the third aspect, wherein the cover is in contact with the cooling unit.

According to the electrical storage device pertaining to the fourth aspect, the impact detection unit and the cooling unit are in contact with each other, and the conductive members can be cooled by the cooling unit, so the resistance values of the conductive members can be inhibited from being changed by heat from the battery cells.

An electrical storage device pertaining to a fifth aspect is the electrical storage device pertaining to the third aspect, wherein the distance from the surface of the cover at the battery cell side to the conductive members is longer than the distance from the surface of the cover at the cooling unit side to the conductive members.

According to the electrical storage device pertaining to the fifth aspect, the distance from the surface of the cover at the battery cell side to the conductive members is longer than the distance from the surface of the cover at the cooling unit side to the conductive members. For this reason, it can be made unlikely for the conductive members and the battery cells to come into contact with each other when the conductive members break or deform when an impact load is input to the electrical storage device.

An electrical storage device pertaining to a sixth aspect is the electrical storage device pertaining to any one of the first aspect to the fifth aspect, further including a monitoring unit that monitors the statuses of the battery cells, wherein voltages output from the conductive members are input to the monitoring unit.

According to the electrical storage unit pertaining to the sixth aspect, the statuses of the battery cells can be monitored by the monitoring unit. Furthermore, in this aspect, the voltages output from the conductive members can be input to the monitoring unit, so the monitoring unit can also monitor for breakage and deformation of the conductive members. For this reason, in this aspect, the number of parts can be reduced compared with a configuration separately provided with a component that monitors the voltages output from the conductive members.

A method of detecting an impact load input to an electrical storage device pertaining to a seventh aspect includes: disposing, relative to battery cells and a wall portion configuring a part of a battery case that houses the battery cells, an impact detection unit including conductive members that are disposed so as to overlap with the battery cells as viewed from a predetermined direction and have a predetermined voltage applied to them and a cover made of an insulator that covers the parts of the conductive members that overlap with the wall portion and the parts of the conductive members that overlap with the battery cells as viewed from the predetermined direction; and estimating whether an impact load has been input to the battery case by measuring a voltage drop in the conductive members.

According to the method of detecting an impact load input to an electrical storage device pertaining to the seventh aspect, the same action as that of the first aspect is achieved.

A method of detecting an impact load input to an electrical storage device pertaining to an eighth aspect is the method of detecting an impact load input to an electrical storage device pertaining to the seventh aspect, wherein the method determines that an impact load has been input to the battery case when the voltage drop is greater than a threshold value.

According to the method of detecting an impact load input to an electrical storage device pertaining to an eighth aspect, it is determined that an impact load has been input to the battery case when the voltage drop in the conductive members is greater than the threshold value, so accuracy for determining whether an impact load has been input to the battery case can be ensured.

As described above, the electrical storage device and the method of detecting an impact load input to an electrical storage device pertaining to the disclosure have the superior effect that they can detect an impact load input to an electrical storage device.

### BRIEF DESCRIPTION OF THE DRAWINGS

FIG. 1 is a plan view schematically showing the configuration of an electrical storage device pertaining to a first embodiment;
FIG. 2 is a cross-sectional view schematically showing the configuration of the electrical storage device pertaining to the first embodiment (a cross-sectional view in which the electrical storage device is cut along line 2-2 of FIG. 1);
FIG. 3 is a plan view schematically showing the configuration of an impact detection unit provided in the electrical storage device pertaining to the first embodiment;
FIG. 4 is a perspective view schematically showing the configuration of the electrical storage device pertaining to the first embodiment;
FIG. 5 is a cross-sectional view schematically showing the configuration of an electrical storage device pertaining to a second embodiment (a cross-sectional view corresponding to FIG. 2);
FIG. 6 is a cross-sectional view schematically showing the configuration of an electrical storage device pertaining to a third embodiment (a cross-sectional view corresponding to FIG. 2);
FIG. 7 is a plan view schematically showing the configuration of the electrical storage device pertaining to the third embodiment;
FIG. 8 is a side view showing the configuration of an electrical storage device pertaining to a fourth embodiment; and
FIG. 9 is a plan view schematically showing the configuration of an impact detection unit provided in an electrical storage device pertaining to a fifth embodiment.

### DETAILED DESCRIPTION

### <First Embodiment>

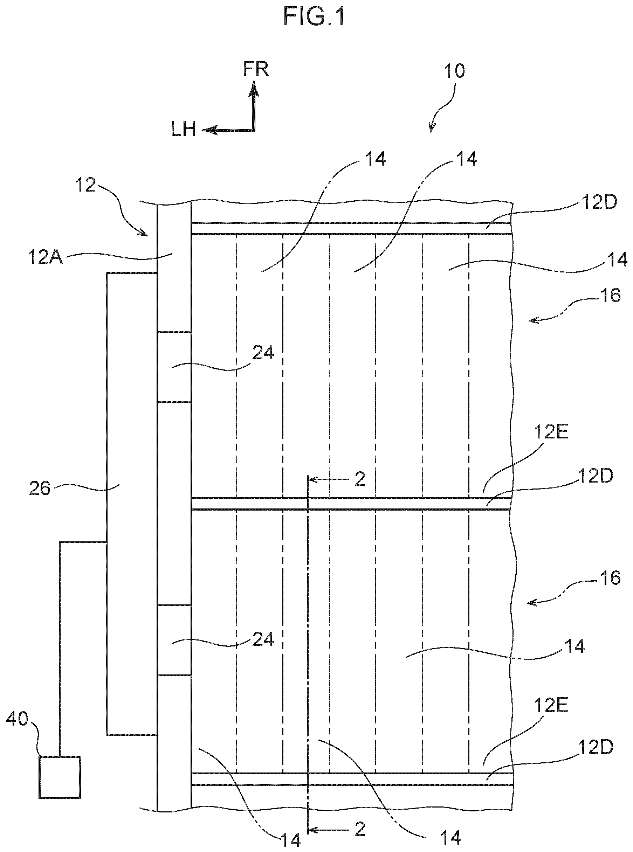

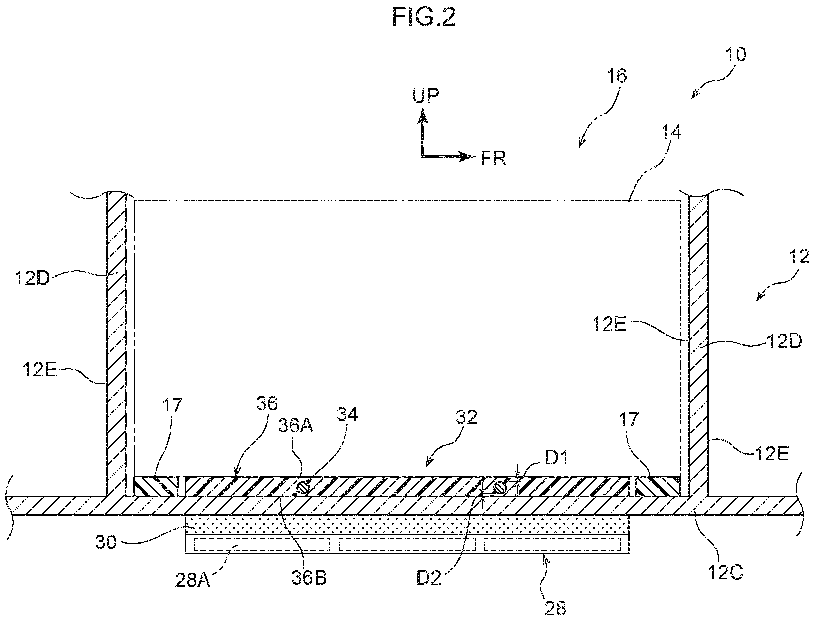

An electrical storage device 10 pertaining to a first embodiment of the disclosure will now be described below using FIG. 1 to FIG. 4. The electrical storage device 10 pertaining to the present embodiment can be installed on the undersurface of a floor of a vehicle (not shown in the drawings) such as a hybrid car, a plug-in hybrid car, and an electric car. As shown in FIG. 1 and FIG. 2, the electrical storage device 10 holds a battery case 12, which configures the outer case of the electrical storage device 10, and a plurality of battery cells 14, which are housed in the battery case 12.

It will be noted that in the drawings arrow FR indicates a forward direction in a front and rear direction of the electrical storage device 10, arrow UP indicates an upward direction in the height direction of the electrical storage device 10, and arrow LH indicates a leftward direction in the width direction of the electrical storage device 10. Furthermore, in the following description, unless otherwise specified, the front and rear direction of the electrical storage device 10 will simply be called the front and rear direction, the height direction of the electrical storage device 10 will simply be called the height direction, and the width direction of the electrical storage device 10 will simply be called the width direction. Furthermore, the front and rear direction of the electrical storage device 10 coincides with the front and rear direction of the vehicle, the height direction of the electrical storage device 10 coincides with the height direction of the vehicle, and the width direction of the electrical storage device 10 coincides with the width direction of the vehicle.

As shown in FIG. 1 and FIG. 2, the battery case 12 is configured by an aluminum alloy as an example. The battery case 12 is configured to include a pair of side wall portions 12A that configure width direction outer parts of the battery case 12, a front wall portion (not shown in the drawings) that configures the front and rear direction front part of the battery case 12, a rear wall portion (not shown in the drawing) that configures the front and rear direction rear part of the battery case 12, a lower wall portion 12C that configures the height direction lower part of the battery case 12, and a plurality of partition wall portions 12D that interconnect the pair of side wall portions 12A and extend in the width direction.

Housing portions 12E are provided between the partition wall portions 12D in the battery case 12, and in the housing portions 12E are housed main parts of battery stacks 16 configured by laminating the battery cells 14 in the width direction. It will be noted that the battery cells 14 are supported on the lower wall portion 12C via insulating legs 17 made of insulators disposed on the height direction underside of the battery cells 14 and on both front and rear direction thereof.

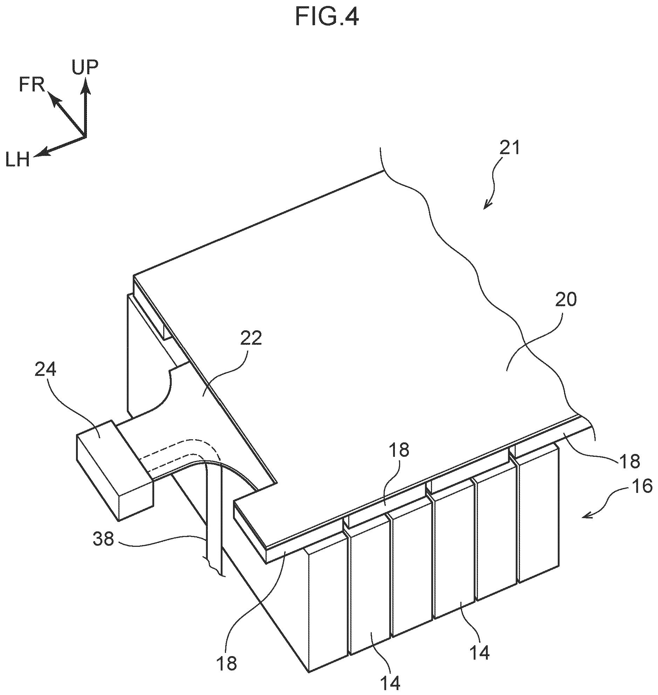

Furthermore, the battery cells 14 each include outer terminals (not shown in the drawings) on the positive pole side and the negative pole side. As shown also in FIG. 4, the outer terminals of the same poles of the battery cells 14 that are adjacent to each other in the width direction are electrically interconnected by bus bars 18 in the width direction. The bus bars 18 are held by a case 20. It will be noted that in the following description the aggregates of the pluralities of bus bars 18 and the cases 20 will be called bus bar modules 21.

The bus bar modules 21 configured as described above are electrically connected to monitoring circuit board units 22. The monitoring circuit board units 22 are configured by flexible printed circuits (FPC) and, as shown in FIG. 1, are electrically connected via connectors 24 provided on end portions thereof to a satellite battery module (SBM) 26 serving as a monitoring unit. In other words, the pluralities of battery cells 14 are electrically connected to the SBM 26 via the bus bar modules 21 and the monitoring circuit board units 22.

The SBM 26 can acquire various types of data relating to the battery cells 14, namely data relating to voltage values, current values, and temperatures, and send those sets of data to a control unit 40 such as an ECU installed in the vehicle.

As shown in FIG. 2, a cooling unit 28 is disposed on the height direction underside of the lower wall portion 12C of the battery case 12. The cooling unit 28 is configured by an aluminum alloy as an example, and flow path units 28A through which flows a heat carrier such as a coolant are formed inside the cooling unit 28. The cooling unit 28 is mounted to the lower wall portion 12C via mounting members (not shown in the drawings).

Furthermore, between the lower wall portion 12C and the cooling unit 28, a heat conducting member 30 configured by a clay-like heat conducting material is interposed.

Here, the present embodiment is characterized in that impact detection units 32 are disposed between the battery cells 14 and the lower wall portion 12C on the height direction upper side of the lower wall portion 12C of the battery case 12. The configuration of the impact detection units 32 will now be described in detail below.

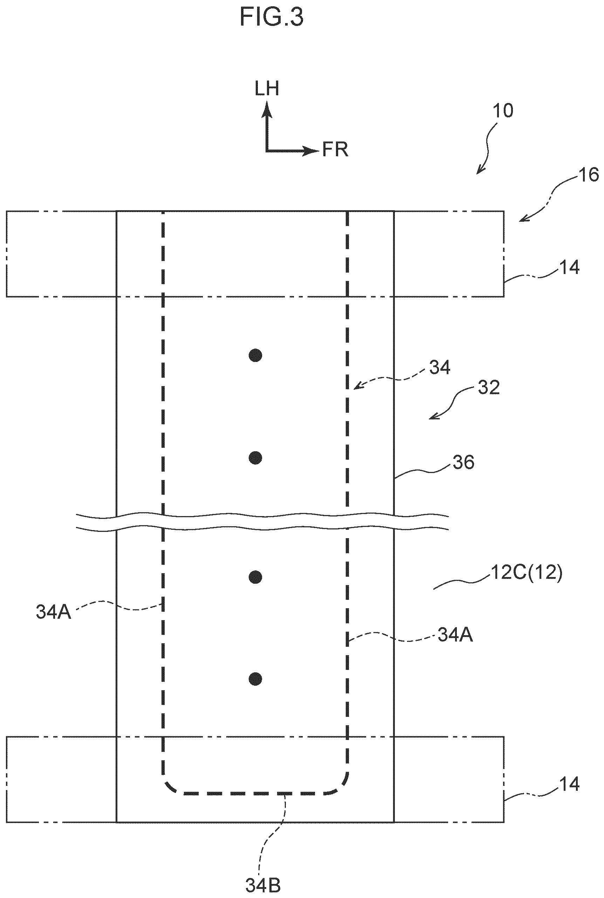

As shown in FIG. 2 and FIG. 3, the impact detection units 32 are disposed one each for each of the battery stacks 16 and are each configured to include a conductive member 34 made of metal and a cover 36 made of an insulator.

Each conductive member 34 is a signal line configured by a single metal wire whose electrical resistance is relatively large and whose wire diameter is about 100 µm, such as a nichrome wire. The conductive members 34 are each disposed such that a part of it overlaps with the battery cells 14 as viewed from the height direction. The conductive members 34 each include a pair of width direction extending portions 34A that extend in the width direction and a front and rear direction extending portion 34B that interconnects the width direction extension portions 34A in the front and rear direction, so that the conductive members 34 are each formed in a U-shape as viewed from the height direction.

It will be noted that the conductive members 34 may, for example, each include four width direction extending portions 34A and three front and rear direction extending portions 34B that interconnect them, so that each signal line is bent in a serpentine fashion as viewed from the height direction. Furthermore, the conductive members 34 may each be configured by a metal foil.

The covers 36 are, for example, rectangular sheets that are made of epoxy resin or the like and whose lengthwise direction coincides with the width direction as viewed from the height direction, and the main parts of the conductive members 34 are embedded inside the covers 36. In other words, the covers 36 cover the parts of the conductive member 34 that overlap with the lower wall portion 12C of the battery case 12 and the battery cells 14 as viewed from the height direction.

It will be noted that the covers 36 are joined via joints (not shown in the drawings) comprising a high thermal conductivity insulation adhesive or the like to the lower wall portion 12C of the battery case 12 and the battery cells 14 in a state in which parts of the covers 36 are in direct contact with the lower wall portion 12C and the battery cells 14. In other words, the covers 36, together with the heat conducting member 30, configure a part of a heat transfer path between the battery cells 14 and the cooling unit 28.

Furthermore, the conductive members 34 are disposed relative to the covers 36 such that a distance D1 from the surfaces of the covers 36 at the battery cell 14 side (i.e., upper surfaces 36A) to the conductive members 34 is longer than a distance D2 from the surfaces of the covers 36 at the cooling unit 28 side (i.e., lower surfaces 36B) to the conductive members 34.

Moreover, as shown in FIG. 4, the conductive members 34 are aggregated to detection circuit boards 38 that extend from the covers 36 and are configured by FPCs, and the detection circuit boards 38 are electrically connected to the connectors 24. That is, the conductive members 34 are electrically connected to the SBM 26 via the detection circuit boards 38.

In the present embodiment, the SBM 26 is configured to apply a predetermined voltage to each of the conductive members 34 every predetermined amount of time based on control by the control unit 40 installed in the vehicle. Furthermore, data relating to the voltage values of the conductive units 34 are acquired by the SBM 26 and sent to the control unit 40.

The control unit 40 compares the voltage values of the conductive members 34 from every predetermined amount of time and determines that an impact load has been input to the battery case 12 when the value of a voltage drop from the voltage value acquired the previous time to the most recently acquired voltage value is greater than a threshold value.

### (Action and Effects of Present Embodiment)

Next, the action and effects of the present embodiment will be described.

In the present embodiment, as shown in FIG. 2, the electrical storage device 10 includes the plural battery cells 14, and by installing the electrical storage device 10 in a vehicle for example, electrical power can be supplied from the battery cells 14 to various devices installed in the vehicle.

In this connection, vehicles usually have an acceleration sensor installed in the front or rear portion of the vehicle body, and although the acceleration sensor can detect an impact load input to the vehicle body, it is difficult for the acceleration sensor to detect whether an impact load has been input to the electrical storage device 10 installed in the vehicle.

Here, in the present embodiment, the impact detection units 32 are disposed relative to the lower wall portion 12C configuring a part of the battery case 12 that houses the battery cells 14, and the impact detection units 32 can detect whether an impact load has been input to the electrical storage device 10.

More specifically, the impact detection units 32 are each configured to include the conductive member 34 and the cover 36 made of an insulator. The conductive members 34 are disposed so as to overlap with the battery cells 14 as viewed from the height direction and have a predetermined voltage applied to them.

The covers 36 cover the parts of the conductive members 34 that overlap with the lower wall portion 12C of the battery case 12 and the battery cells 14 as viewed from the height direction and insulate the conductive members 34 from the lower wall portion 12C and the battery cells 14.

For this reason, in the present embodiment, when, for example, an impact load from under the vehicle is input from an object on the road, the conductive members 34 break or deform with the deformation of the covers 36, resulting in a drop in the voltages output from the conductive members 34. That is, in the present embodiment, whether an impact load has been input to the electrical storage device 10 can be determined based on the voltages output from the conductive members 34.

Furthermore, in the present embodiment, the cooling unit 28 is disposed relative to the lower wall portion 12C of the battery case 12, and the impact detection units 32 are disposed between the battery cells 14 and the cooling unit 28. Heat transfer between the battery cells 14 and the cooling unit 28 is performed via the covers 36.

For this reason, in the present embodiment, during cooling of the battery cells 14 by the cooling unit 28, heat exchange between the cooling unit 28 and the battery cells 14 can be promoted and the efficiency with which the battery cells 14 are cooled can be improved.

Furthermore, in the present embodiment, the covers 36 and the battery cells 14 are in contact with each other, and an impact load that is input to the battery cells 14 and an impact load that is input to the impact detection units 32 can be approximated.

Furthermore, in the present embodiment, the distance D1 from the upper surfaces 36A of the covers 36 at the battery cell 14 side to the conductive members 34 is longer than the distance D2 from the lower surfaces 36B of the covers 36 at the cooling unit 28 side to the conductive members 34. For this reason, it can be made unlikely for the conductive members 34 and the battery cells 14 to come into contact each other when the conductive members 34 break or deform when an impact load is input to the electrical storage device 10.

Furthermore, in the present embodiment, as shown in FIG. 1, the statuses of the battery cells 14 can be monitored by the SBM 26. Furthermore, in the present embodiment, the voltages output from the conductive members 34 can be input to the SBM 26, so the SBM 26 can also monitor for breakage and deformation of the conductive members 34. For this reason, in the present embodiment, the number of parts can be reduced compared with a configuration separately provided with a component that monitors the voltages output from the conductive members 34. It will be noted that "monitor" in this specification refers to a state in which the devices to be monitored (in the above example, the battery cells 14 or the conductive members 34) are electrically connected, or are connected by communicating means, to the device that monitors them (in the above example, the SBM 26, and particularly the circuits in the SBM 26).

Furthermore, in the present embodiment, the control unit 40 estimates whether an impact load has been input to the battery case 12 by measuring the voltage drop in the conductive members 34 based on the data acquired from the SBM 26.

Specifically, in the present embodiment, it is determined by the control unit 40 that an impact load has been input to the battery case 12 when the voltage drop in the conductive members 34 is greater than the threshold value, so accuracy for determining whether an impact load has been input to the battery case 12 can be ensured.

As described above, in the present embodiment, an impact load input to the electrical storage device 10 can be detected.

### <Second Embodiment>

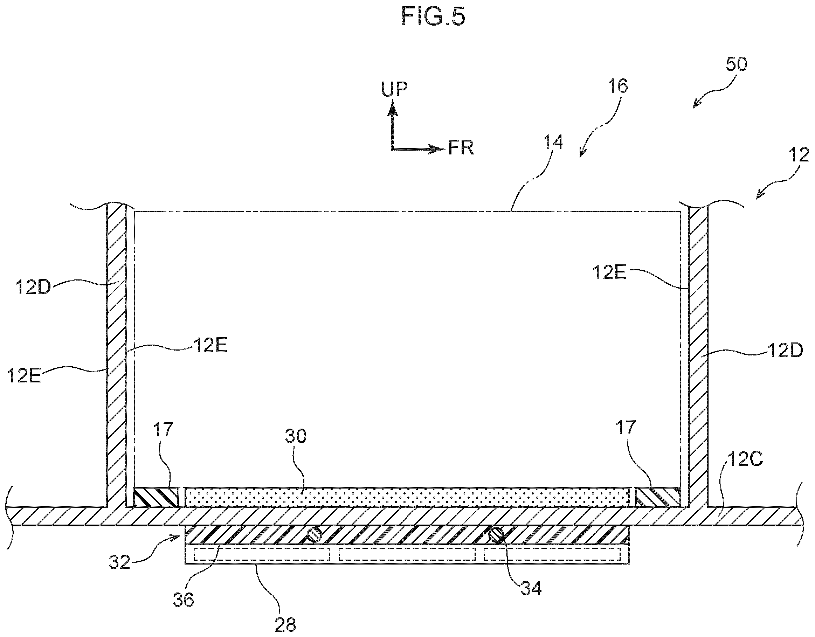

An electrical storage device 50 pertaining to a second embodiment of the disclosure will now be described below using FIG. 5. It will be noted that components identical to those of the first embodiment are assigned identical numbers, and description thereof will be omitted.

The electrical storage device 50 basically has the same configuration as the first embodiment, but the positions of the heat conducting member 30 and the impact detection units 32 are switched. That is, in the present embodiment, the covers 36 of the impact detection units 32 are in contact with the cooling unit 28.

According to this configuration, basically the same action and effects as those of the first embodiment are achieved. Furthermore, in the present embodiment, the impact detection units 32 and the cooling unit 28 are in contact with each other, and the conductive members 34 can be cooled by the cooling unit 28, so the resistance values of the conductive members 34 can be inhibited from being changed by heat from the battery cells 14.

### <Third Embodiment>

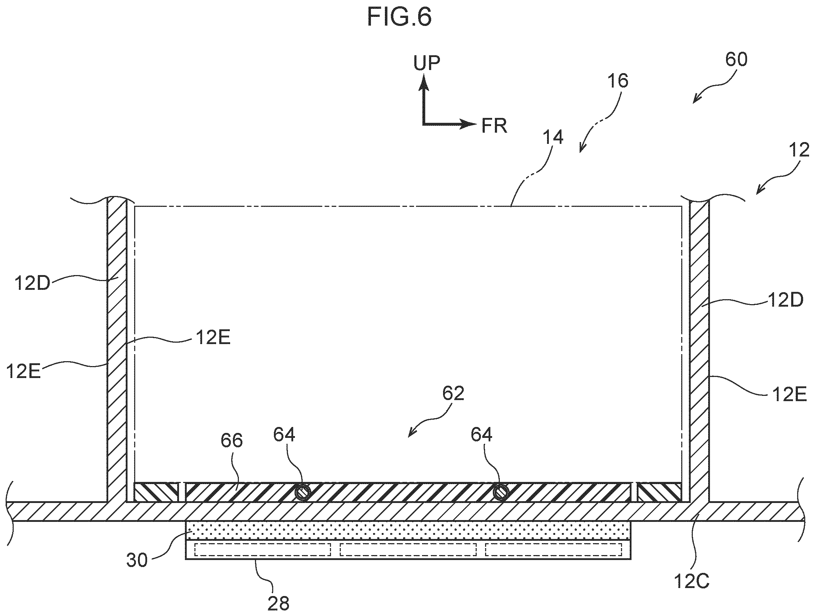

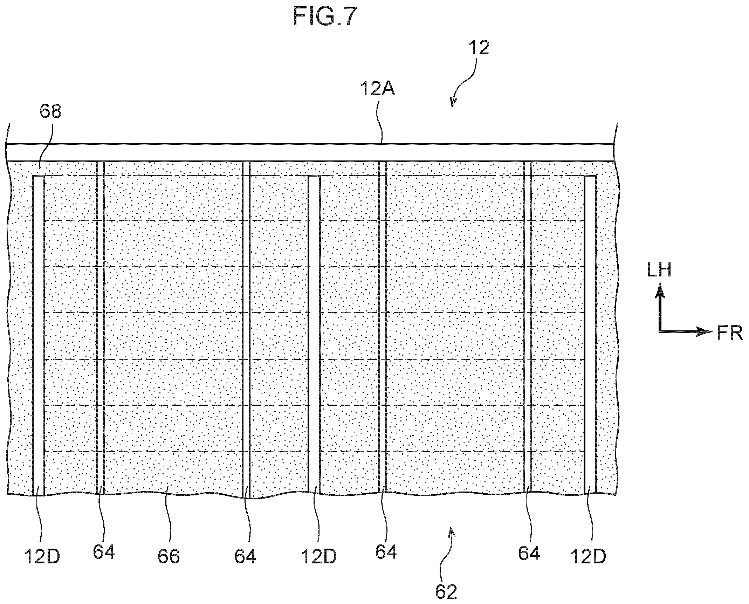

An electrical storage device 60 pertaining to a third embodiment of the disclosure will now be described below using FIG. 6 and FIG. 7. It will be noted that components identical to those of the first embodiment are assigned identical numbers, and description thereof will be omitted.

The electrical storage device 60 basically has the same configuration as the first embodiment, but conductive members 64 of an impact detection unit 62 are coated wires coated with a vinyl resin. Furthermore, a cover 66 in which the conductive members 64 are embedded is configured by flowing molten resin between the lower wall portion 12C of the battery case 12 and the battery cells 14.

More specifically, in the present embodiment, slit portions 68 are provided between the side wall portions 12A and the partition wall portions 12D and between the rear wall portion and the partition wall portions 12D in the battery case 12.

The cover 66 is configured by flowing molten resin between the battery cells 14 and the battery case 12 in a state in which the battery cells 14 and the conductive members 64 have been installed relative to the battery case 12 and solidifying the resin after it has passed though the slit portions 68 and spread on the entire upper surface of the lower wall portion 12C.

According to this configuration, basically the same action and effects as those of the first embodiment are achieved. Furthermore, in the present embodiment, the number of parts can be reduced compared with a configuration where an impact detection unit is disposed for each of the battery stacks 16.

### <Fourth Embodiment>

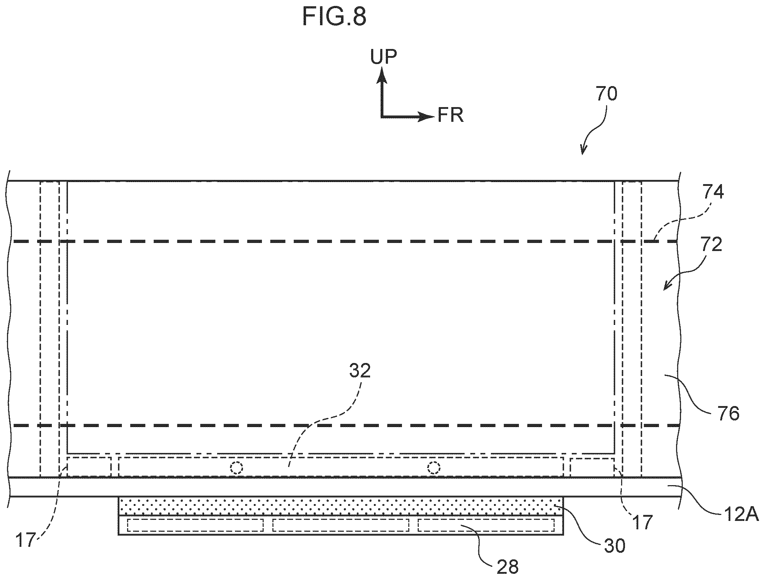

An electrical storage device 70 pertaining to a fourth embodiment of the disclosure will now be described below using FIG. 8. It will be noted that components identical to those of the first embodiment are assigned identical numbers, and description thereof will be omitted.

The electrical storage device 70 basically has the same configuration as the first embodiment, but impact detection units 72 having the same configuration as the impact detection units 32 are attached to the side wall portions 12A of the battery case 12.

More specifically, the impact detection units 72 are each configured to include conductive members 74 and a cover 76 and are disposed such that their lengthwise direction coincides with the front and rear direction on the surfaces of the side wall portions 12A opposite from the battery cells 14.

According to this configuration, basically the same action and effects as those of the first embodiment are achieved. Furthermore, in the present embodiment, the impact detection units 72 are provided relative to the side wall portions 12A of the battery case 12, and an impact load input in the vehicle width direction to the electrical storage device 70 can be detected using the impact detection units 72.

### <Fifth Embodiment>

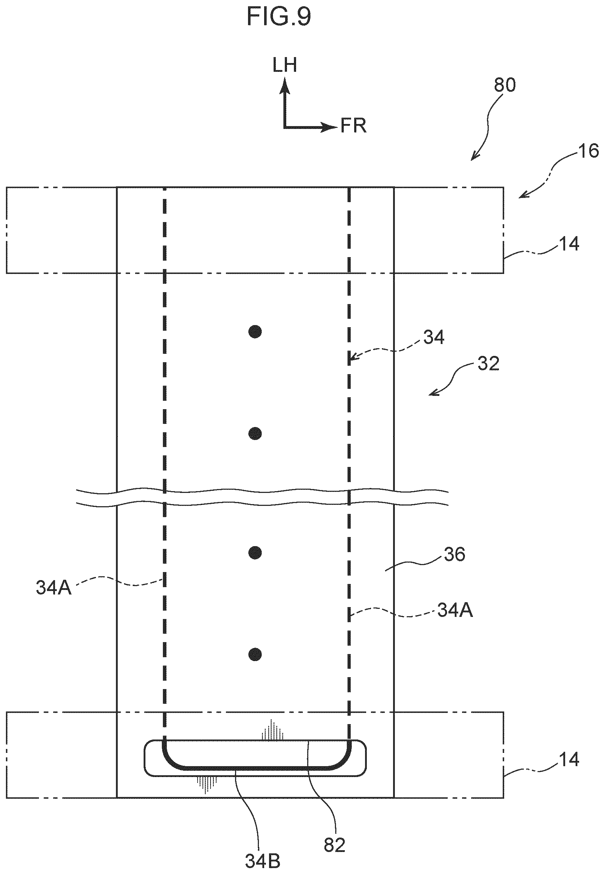

An electrical storage device 80 pertaining to a fifth embodiment of the disclosure will now be described below using FIG. 9. It will be noted that components identical to those of the first embodiment are assigned identical numbers, and description thereof will be omitted.

The electrical storage device 80 basically has the same configuration as the first embodiment, but long hole portions 82 extending in the front and rear direction are formed in end portions of the covers 36, and the front and rear direction extending portions 34B of the conductive members 34 are exposed inside the long hole portions 82.

Furthermore, in the present embodiment, the SBM 26 can detect a short circuit between the conductive members 34 and the battery case 12, and the control unit 40 is configured to determine that there is a fault current in the battery case 12 when the SBM 26 detects a short circuit between the conductive members 34 and the battery case 12.

According to this configuration, basically the same action and effects as those of the first embodiment are achieved. Furthermore, in the present embodiment, when water collects inside the long hole portions 82 when water droplets form in the battery case 12, the conductive members 34 and the battery case form a short circuit, and the control unit 40 can detect a fault current in the battery case 12 based on information acquired from the SBM 26.

In other words, in the present embodiment, the same parts can be used to detect an impact load input to the electrical storage device 80 and a fault current in the battery case 12.

### <Supplemental Description of Above Embodiments>

(1) In the above embodiments, the conductive members provided in the impact detection units are connected to the SBM 26 via the connectors 24 connected to the bus bar modules 21, but depending on the vehicle specifications and the like, a configuration where the conductive members are connected to dedicated connectors for the conductive members and the connectors are connected to the SBM 26 may also be employed.
(2) Furthermore, in the above embodiments, the battery case 12 and the cooling unit 28 are separately configured, but depending on the vehicle specifications and the like, a configuration where the lower wall portion 12C of the battery case 12 and the cooling unit 28 are integrated may also be employed.

## Claims

1. An electrical storage device (10, 50, 60, 70, 80), comprising:
a plurality of battery cells (14);
a battery case (12) that houses the battery cells (14); and
an impact detection unit (32, 62, 72) disposed relative to a wall portion (12C, 12A) configuring a part of the battery case (12), the impact detection unit (32, 62, 72) including conductive members (34, 64, 74) that are disposed so as to overlap with the battery cells (14) as viewed from a predetermined direction and the conducting members (34, 64, 74) have a predetermined voltage applied to them, and the impact detection unit (32, 62, 72) including a cover (36, 66, 76) that is made of an insulator and that covers parts of the conductive members (34, 64, 74) which overlap with the wall portion (12C, 12A) and parts of the conductive members (34, 64, 74) which overlap with the battery cells (14) as viewed from the predetermined direction.

2. The electrical storage device (10, 50, 60, 70, 80) of claim 1, further comprising a cooling unit (28) that is disposed relative to the wall portion (12C, 12A), wherein the impact detection unit (32, 62, 72) is disposed between the battery cells (14) and the cooling unit (28), and heat transfer between the battery cells (14) and the cooling unit (28) is performed via the cover (36, 66, 76).

3. The electrical storage device (10, 60, 70, 80) of claim 2, wherein the cover (36, 66, 76) is in contact with the battery cells (14).

4. The electrical storage device (50, 60, 70, 80) of claim 2, wherein the cover (36, 66, 76) is in contact with the cooling unit (28).

5. The electrical storage device (10, 60, 70, 80) of claim 3, wherein a distance (D1) from a surface (36A) of the cover (36, 66, 76) at a battery cell (14) side to the conductive members (34, 64, 74) is longer than a distance (D2) from a surface (36B) of the cover (36, 66, 76) at a cooling unit (28) side to the conductive members (34, 64, 74).

6. The electrical storage device (10, 50, 60, 70, 80) of any one of claim 1 to claim 5, further comprising a monitoring unit (26) that monitors statuses of the battery cells (14), wherein voltages output from the conductive members (34, 64, 74) are input to the monitoring unit (26).

7. A method of detecting an impact load input to an electrical storage device (10, 50, 60, 70, 80), the method comprising:
disposing, relative to battery cells (14) and a wall portion (12C, 12A) configuring a part of a battery case (12) that houses the battery cells (14), an impact detection unit (32, 62, 72) including conductive members (34, 64, 74) that are disposed so as to overlap with the battery cells (14) as viewed from a predetermined direction and that have a predetermined voltage applied to them, and the impact detection unit (32, 62, 72) including a cover (36, 66, 76) that is made of an insulator and that covers parts of the conductive members (34, 64, 74) which overlap with the wall portion (12C, 12A) and parts of the conductive members (34, 64, 74) which overlap with the battery cells (14) as viewed from the predetermined direction; and
estimating whether an impact load has been input to the battery case (12) by measuring a voltage drop in the conductive members (34, 64, 74).

8. The method of detecting an impact load input to an electrical storage device (10, 50, 60, 70, 80) of claim 7, wherein the method determines that an impact load has been input to the battery case (12) in a case in which the voltage drop is greater than a threshold value.
